(19) Europäisches Patentamt
European Patent Office
Office européen des brevets

(11) **EP 1 339 165 B1**

(12) **EUROPÄISCHE PATENTSCHRIFT**

(45) Veröffentlichungstag und Bekanntmachung des Hinweises auf die Patenterteilung:
**09.08.2006 Patentblatt 2006/32**

(21) Anmeldenummer: **03003327.8**

(22) Anmeldetag: **13.02.2003**

(51) Int Cl.:
*H03B 5/18* (2006.01)          *H01Q 23/00* (2006.01)
*G01S 13/56* (2006.01)

(54) **Mikrowellen-Sensor**

Microwave-sensor

Détecteur à micro-ondes

(84) Benannte Vertragsstaaten:
**DE FR GB**

(30) Priorität: **13.02.2002 DE 10206074**

(43) Veröffentlichungstag der Anmeldung:
**27.08.2003 Patentblatt 2003/35**

(73) Patentinhaber: **i f m electronic gmbh**
**D-45127 Essen (DE)**

(72) Erfinder: **Palata, Jaromir**
**88085 Langenargen (DE)**

(74) Vertreter: **Gesthuysen, von Rohr & Eggert**
**Patentanwälte**
**Postfach 10 13 54**
**45013 Essen (DE)**

(56) Entgegenhaltungen:
**EP-A- 0 636 899          US-A- 3 833 905**

- **BIRKELAND J ET AL: "FET-BASED PLANAR CIRCUITS FOR QUASI-OPTICAL SOURCES AND TRANSCEIVERS" IEEE TRANSACTIONS ON MICROWAVE THEORY AND TECHNIQUES, IEEE INC. NEW YORK, US, Bd. 37, Nr. 9, 1. September 1989 (1989-09-01), Seiten 1452-1459, XP000038645 ISSN: 0018-9480**
- **U. TIETZE, C. SCHENK: "Halbleiter-Schaltungstechnik" 1993 , SPRINGER-VERLAG BERLIN , HEIDELBERG XP002242899 * Seite 51, Absatz 2 ***
- **SIRONENE M ET AL: "A SUBHARMONIC SELF-OSCILLATING MIXER WITH INTEGRATED ANTENNA FOR 60-GHZ WIRELESS APPLICATIONS" IEEE TRANSACTIONS ON MICROWAVE THEORY AND TECHNIQUES, IEEE INC. NEW YORK, US, Bd. 49, Nr. 3, März 2001 (2001-03), Seiten 442-450, XP001086702 ISSN: 0018-9480**

**Beschreibung**

Die Erfindung betrifft einen Mikrowellen-Sensor mit einer Strom- bzw. Spannungsversorgung, mit einem selbstmischenden Oszillator, mit einer Sende- und Empfangsantenne und mit einer Auswerteschaltung, wobei der selbstmischende Oszillator sowohl das Sendesignal erzeugt als auch das Sendesignal mit dem Empfangssignal mischt und wobei der selbstmischende Oszillator als Gegentaktoszillator mit zwei Transistoren ausgebildet ist.

Bei einem ersten Typ von Mikrowellen-Sensoren der zuvor beschriebenen Art wird die Bewegung eines Gegenstandes in einem zu überwachenden Bereich dadurch festgestellt, daß der sogenannte Doppler-Effekt ausgewertet wird. Ein von einem Sender ausgestrahltes Sendesignal mit einer Frequenz $f_1$ wird von einem sich im zu überwachenden Bereich bewegenden Objekt reflektiert. Ein Teil des reflektierten Signals trifft als Empfangssignal mit der Frequenz $f_2$ auf den Empfänger. In einem geeignetem Mischer wird das Empfangssignal mit dem Sendesignal gemischt und anschließend der Anteil des Mischprodukts mit der Doppler-Frequenz $f_D$ ausgewertet. Für die Doppler-Frequenz $f_D$ gelten dabei folgende Gleichungen

$$f_D = f_1 - f_2$$

und

$$f_D = \frac{2 \cdot f_1}{c_0} \cdot v_r$$

wobei mit $c_0$ die Lichtgeschwindigkeit und mit $v_r$ die Radialgeschwindigkeit des sich bewegenden Objekts bezeichnet ist.

Aus der gemessenen Doppler-Frequenz $f_D$ kann somit entweder die Radialgeschwindigkeit $v_r$ des sich bewegenden Objekts gemessen werden oder, wenn der Mikrowellen-Sensor nur zur Überwachung eines Raumes oder eines bestimmten Bereiches dient, der Eintritt eines Objekts in den zu überwachenden Raum bzw. Bereich festgestellt werden. Ein derartiger, den Doppler-Effekt auswertender Mikrowellen-Sensor - der häufig auch als Doppler-Sensor bezeichnet wird - kann somit als Bewegungsmelder für unterschiedlichste Anwendungen eingesetzt werden.

Bei einem zweiten Typ von Mikrowellen-Sensoren der zuvor beschriebenen Art zur Detektion eines bewegten oder unbewegten Gegenstandes in einem zu überwachenden Bereich wird ein frequenzmoduliertes Sendesignal mit einer Frequenz $f_1(t)$ von einem Sender ausgestrahlte. Das Modulationssignal wird dabei von einem geeigneten Modulationsgenerator erzeugt, wobei die Veränderung der Frequenz $f_1(t)$ des Sendesignals linear, sinusförmig oder nach einer anderen Zeitfunktion erfolgen kann. Dieses Radarverfahren wird als Dauerstrichradar mit Frequenzmodulation bzw. als FMCW-Radar (FMCW = Frequency Modulated Continuous Wave) bezeichnet.

Auch hier wird das Sendesignal mit der Frequenz $f_1(t_0)$ von einem sich im zu überwachenden Bereich befindenden Objekt reflektiert. Ein Teil des reflektierten Signals trifft nach der Zeitdauer $\Delta t$ als Empfangssignal mit der Frequenz $f_1(t_0)$ auf den Empfänger. Zu diesem Zeitpunkt hat das Sendesignal bereits die Frequenz $f_1(t_0 + \Delta t)$. Das Empfangssignal läuft somit in seiner Frequenz derjenigen des Sendesignals hinterher. In einem geeignetem Mischer wird das Empfangssignal mit dem Sendesignal gemischt und anschließend der Anteil des Mischprodukts mit der Frequenz $f_{ZF}$ ausgewertet.

Der in Rede stehende Mikrowellen-Sensor kann sowohl als Doppler-Sensor als auch als FMCW-Sensor verwendet werden. Dabei kann die Frequenz des Senders je nach Anwendungsbeispiel zwischen 60 MHz und 60 GHz liegen und somit auch etwas unterhalb des eigentlichen Mikrowellenbereichs liegen, der normalerweise von 300 MHz bis 300 GHz reicht. Genau genommen handelt es sich bei dem in Rede stehenden Sensor somit um einen Radio- bzw. Mikrowellensensor.

Eingangs ist ausgeführt worden, daß der Mikrowellen-Sensor einen selbstmischenden Oszillator und eine Sende- und Empfangsantenne aufweist. Ein selbstmischender Oszillator, der auch als selbstschwingender Mischer bezeichnet werden kann, ist ein Bauteil, das sowohl als Oszillator als auch als Mischer eingesetzt wird. Zum einen wird also durch den selbstmischenden Oszillator das Sendesignal erzeugt, zum anderen wird in dem selbstmischenden Oszillator - der dann als selbstschwingender Mischer arbeitet - das Empfangssignal mit dem Sendesignal gemischt. Unter einer Sende- und Empfangsantenne soll im Rahmen dieser Anmeldung ein Bauteil verstanden werden, das gleichzeitig als Sendeantenne und als Empfangsantenne verwendet wird.

Ein derartiger Mikrowellen-Sensor, bei dem anstelle der vier Bauteile - Oszillator, Mischer, Sendeantenne und Empfangsantenne - nur die zuvor beschriebenen beiden Bauteile - selbstmischender Oszillator und Sende- und Empfangsantenne - verwendet werden, ist aus der DE 32 09 093 A1 und aus der DE 41 27 892 A1 bekannt. Bei den bekannten Mikrowellen-Sensoren wird der selbstmischende Oszillator durch einen rückgekoppelten Feldeffekt-Transistor gebildet, in dessen Source-Drain-Stromkreis ein Widerstand zum Abgriff des Doppler-Signals vorgesehen ist. Mit den bekannten Mikrowellen-Sensoren ist es bereits gelungen, eine Vorrichtung zur Raumüberwachung mittels Doppler-Radar zur Verfügung zu stellen, die nur relativ wenige Bauteile benötigt und daher sowohl kostensparend hergestellt werden kann als auch nur einen geringen Raumbedarf und ein geringes Gewicht aufweist.

Insbesondere wenn ein solcher Mikrowellen-Sensor als 2-Leiter-Gerät ausgebildet ist oder nur durch eine Batterie betrieben werden soll, besteht jedoch das Problem, daß die bekannten Mikrowellen-Sensoren einen zu großen Energieverbrauch aufweisen oder bei geringem Energieverbrauch eine zu geringe Sendeleistung haben. Ein derartiger als 2-Leiter-Gerät ausgebildeter Mikrowellen-Sensor kann auch als Mikrowellen-Näherungsschalter bezeichnet werden.

Aus der US 3,833,905 ist ein eingangs beschriebener Mikrowellen-Sensor bekannt, bei dem als selbstmischender Oszillator ein Gegentaktoszillators verwendet wird. Die Verwendung eines Gegentaktoszillators hat den Vorteil, daß dadurch eine höhere Leistung und ein besserer Wirkungsgrad erreichbar sind, so daß ein solcher Gegentaktoszillator bereits bei einer relativ niedrigen Spannung bzw. bei einem relativ geringem Strom gut anschwingt. Insbesondere ein symmetrisch aufgebauter Gegentaktoszillator ist im Vergleich zu Feldeffekt-Transistoren wesentlich schwingfreudiger, wobei zusätzlich auch weniger Oberschwingungen auftreten.

Der vorliegenden Erfindung liegt daher die Aufgabe zugrunde, den eingangs beschriebenen Mikrowellen-Sensor derart zu verbessern, daß er einen geringeren Energieverbrauch aufweist und möglichst kostengünstig hergestellt werden kann. Darüber hinaus soll der Mikrowellen-Sensor für Gegenstände mit unterschiedlichen Geschwindigkeiten sensitiv sein.

Diese Aufgabe ist bei dem eingangs beschriebenen Mikrowellen-Sensor dadurch gelöst, daß eine Impedanz zwischen die Strom- bzw. Spannungsversorgung und den Oszillator geschaltet ist und das niederfrequente Mischprodukt an der Impedanz abgegriffen und der Auswerteschaltung zugeführt wird, daß die Impedanz einen frequenzabhängigen Widerstandswert aufweist, wobei die Impedanz so ausgelegt ist, daß sie für die Gleichstrom- bzw, Gleichspannungsversorgung des selbstmischenden Oszillator niederohmig und für das Doppler-Signal bzw, das Zwischensignal hochohmig ist. Dadurch, daß der Mikrowellen-Sensor eine Impedanz aufweist, die zwischen die Strom bzw. Spannungsversorgung und den selbstmischenden Oszillator geschaltet ist, kann das Doppler-Signal einfach an der Impedanz abgegriffen und der Auswerteschaltung zugeführt wird.

Soll der erfindungsgemäße Mikrowellen-Sensor nur einen minimalen Stromverbrauch aufweisen und mit möglichst geringen Kosten und somit auch mit möglichst wenig Bauteilen realisiert werden, so kann die Impedanz einfach als ohmscher Widerstand ausgebildet sein. Ein solcher Mikrowellen-Sensor eignet sich besonders für den Batteriebetrieb, da der Mikrowellen-Sensor dann nur einen Stromverbrauch von weniger als 0,5 mA aufweist. Aufgrund des sehr schwingfreudigen Gegentaktoszillators ist sogar ein noch geringerer Strom für den Betrieb des selbstmischenden Oszillators ausreichend. Ein derartiger Mikrowellen-Sensor kann beispielsweise in einem Türgriff eines Kraftfahrzeuges integriert werden, wo der Mikrowellen-Sensor die Annäherung einer Hand an den Türgriff feststellt und beim Ansprechen einen Transponder zur Abfrage der Zugangsberechtigung aktiviert. Ebenso ist ein derartiger Mikrowellen-Sensor als Näherungsschalter in Sanitäranlagen - WC-Spülungen oder Hände-Trockner - oder in Fußgängerampeln einsetzbar. Mit einem derartigen, auf minimalen Energieverbrauch optimierten Mikrowellen-Sensor, der daneben auch nur sehr geringe Abmessungen aufweist, ist jedoch nur eine geringe Reichweite von einigen Zentimetern - bis etwa 10 bis 20 cm - realisierbar, so daß der Mikrowellen-Sensor auch nur einen entsprechend kleinen - bei den zuvor genannten Einsatzgebieten jedoch ausreichenden - Raumbereich überwachen kann.

Erfindungsgemäß wird jedoch eine Impedanz verwendet, die einen frequenzabhängigen Widerstandwert aufweist. Die Impedanz ist dabei so ausgelegt, daß sie für die Gleichspannungs- bzw. Gleichstromversorgung des selbstmischenden Oszillators niederohmig ist, für das Doppler-Signal bzw. das Zwischensignal jedoch möglichst hochohmig ist. Dadurch ist eine gute breitbandige Auskopplung des Doppler-Signals möglich, so daß Gegenstände mit unterschiedlichen Geschwindigkeiten detektiert werden können. Mit einem derartigen Mikrowellen-Sensor kann eine größere Reichweite erzielt werden, wobei dennoch der Energieverbrauch gering gehalten wird.

Die Verwendung einer Impedanz mit einem zuvor beschriebenen frequenzabhängigen Widerstandswert hat den Vorteil, daß zum einen durch die Niederohmigkeit für die Gleichstromversorgung den Transistoren des Gegentaktoszillators relativ viel Strom zugeführt werden kann, so daß eine relativ hohe Sendeleistung zur Verfügung steht. Zum anderen hat eine solche Impedanz aufgrund ihrer Hochohmigkeit für das Doppler-Signal den Vorteil, daß eine hohe Verstärkung erreicht wird.

Eine derartige Impedanz kann durch eine Drossel, insbesondere eine elektronische Drossel, beispielsweise einen Gyrator, realisiert sein. Ein Gyrator hat den Vorteil, daß er für die Gleichstromversorgung sehr neiderohmig, für die NF-Signale und die HF-Signale jedoch sehr hochohmig ist, was zu der gewünschten hohen Verstärkung des Nutzsignal führt.

Die Sende- und Empfangsantenne wird vorteilhafter weise durch eine die Frequenz des Oszillators bestimmende Streifenleitung gebildet. Durch die Verwendung einer Streifenleitung als Sende- und Empfangsantenne, die Bestandteil des Gegentaktoszillators ist, ist es möglich, ein weiteres Bauteil einzusparen, da keine separate Sende- und Empfangsantenne mehr benötigt wird. Daneben ist es jedoch auch möglich, als Sende- und Empfangsantenne eine Dipolantenne zu verwenden.

Gemäß einer bevorzugten Ausgestaltung des erfindungsgemäßen Mikrowellen-Sensors ist zur Einstellung bzw. Stabilisierung des Arbeitspunktes des Mikrowellen-Sensors eine Spannungsgegenkopplung mit mindestens einem Widerstand und mit einem Tiefpass realisiert.

Bei dem aus der DE 41 27 892 A1 bekannten Doppler-Sensor ist zur Stabilisierung des Arbeitspunktes des Transistors eine Stromgegenkopplung realisiert, wozu zwischen den Drain-Anschluß bzw. den Gate-Anschluß des FeldeffektTransistors und Masse jeweils eine Impedanz geschaltet ist. Eine derartige Stromgegenkopplung zur Einstellung des Arbeitspunktes führt zum einen zu einem nicht gewünschten Querstrom, was den insgesamt benötigten Energiebedarf des Mikrowellen-Sensors erhöht. Zum anderen besteht bei einer Arbeitspunkteinstellung mittels Stromgegenkopplung die Gefahr, daß durch die Gegenkopplung auch das Nutzsignal, d. h. das Doppler-Signal "weggeregelt" oder zumindest geschwächt wird.

Dadurch, daß die Arbeitspunkteinstellung durch eine Spannungsgegenkopplung realisiert wird, wird zunächst ein ungewollter Querstrom vermieden. Darüber hinaus wird durch den vorgesehenen Tiefpass sichergestellt, daß nur eine eventuelle Temperatur-Drift ausgeregelt, nicht jedoch das Doppler-Signal geschwächt wird. Hierzu wird der Tiefpass so eingestellt, daß die Arbeitspunktregelung langsamer als die niedrigste zu erwartende Doppler-Frequenz $f_D$ bzw. die niedrigste Zwischenfrequenz $f_{ZF}$ ist. Bei einem Sendesignal mit einer Frequenz $f_1$ von einigen Giga-Hertz, beispielsweise 2,5 GHz und einer Abstimmung des Mikrowellen-Sensors auf von Menschen ausgeübte Bewegungen, beispielsweise auf die Annäherung einer Hand an einen Türgriff, beträgt beispielsweise die Doppler-Frequenz $f_D$ zwischen 10 und 50 Hz, so daß die Grenzfrequenz des Tiefpasses entsprechend kleiner als 10 Hz gewählt werden muß. Vorzugsweise beträgt die Grenzfrequenz des Tiefpasses etwa 1/3 der niedrigsten erwarteten Doppler-Frequenz $f_D$ bzw. die niedrigste Zwischenfrequenz $f_{ZF}$. Bei einer derartigen Einstellung bzw. Stabilisierung des Arbeitspunktes werden nur sehr wenige Bauteile benötigt. Insbesondere kann der Widerstand, der zur Spannungsgegenkopplung benutzt wird, gleichzeitig auch Bestandteil des Tiefpasses sein. Dann sind für die Arbeitspunkteregelung nur ein Widerstand und ein, vorzugsweise zwei Kondensatoren erforderlich.

Bei einer alternativen Ausgestaltung des erfindungsgemäßen Mikrowellen-Sensors erfolgt die Stabilisierung bzw. die Einstellung des Arbeitspunktes mit Hilfe einer Stromregelung mit mindestens einem Tiefpaß. Durch den Tiefpass wird wiederum sichergestellt, daß nur eine eventuelle Temperatur-Drift ausgeregelt, nicht jedoch das Doppler-Signal bzw. das Zwischensignal geschwächt wird. Die Stromregelung erfolgt dabei über eine Veränderung des Basisstroms der Oszillatortransistoren des Gegentaktoszillators. Dabei kann der Anschluß der Arbeitspunktregelung direkt an den Basen der Oszillatortransistoren oder am Mittenanschluß der Streifenleitung erfolgen.

Die Regelung des Arbeitspunktes kann außerdem mit Hilfe eines Komparators und eines Tiefpasses oder eines Integrators erfolgen. Als Komparator wird beispielsweise ein entsprechend beschalteter Operationsverstärker verwendet. Auch eine derartig aufgebaute

Regelung erfolgt mit einer Frequenz, die geringer ist als die kleinste erwartete Doppler-Frequenz $f_D$. Da durch die Arbeitspunkteinstellung bzw. -regelung nur eine eventuell auftretende Temperatur-Drift der Transistoren kompensiert werden soll - die zu einem gegebenen Kollektorstrom gehörige Basis-Emitter-Spannung eines Transistors nimmt um ca. 2 mV je Grad Temperaturerhöhung ab - ist hierzu eine Arbeitspunktregelung mit einer Frequenz von nur einigen Hertz ausreichend.

Zur Vergrößerung der Frequenzstabilität des Gegentaktoszillators kann die Streifenleitung mit einem dielektrischen Resonator verbunden sein. Ein solcher dielektrischer Resonator übernimmt dann aufgrund seiner höheren Güte die Frequenzführung des Gegentaktoszillators. Die Verwendung eines dielektrischen Resonators ist insbesondere dann vorteilhaft, wenn der Mikrowellen-Sensor in unmittelbarer Nähe zu anderen elektronischen Geräten und Schaltungen eingesetzt werden soll, so daß sichergestellt werden muß, daß diese elektronischen Geräten und Schaltungen durch das abgestrahlte Sendesignal nicht beeinträchtigt werden.

Die Streifenleitung ist vorteilhafterweise als $\lambda/2$ (Lambda-Halbe) Mikrostreifenleitung ausgebildet. Die Abstimmung der Länge der Mikrostreifenleitung auf die Frequenz $f_1$ des Sendesignals hat den Vorteil, daß bei einer Wahl der Länge der Mikrostreifenleitung entsprechend der halben Wellenlänge des Sendesignals der Spannungsnullpunkt des sinusförmigen Sendesignals in der geometrischen Mitte der Mikrostreifenleitung liegt, wodurch der Anschluß für die Arbeitspunktregelung leicht realisierbar ist, insbesondere Drosseln zur Einkoppelung nicht erforderlich sind. Zur Verbesserung der Richtcharakteristik der Streifenleitung weist diese eine Hinterkupferung auf, wodurch die Abstrahlcharakteristik der Streifenleitung etwa einem Rotationsellipsoid entspricht.

Grundsätzlich gibt es verschiedene Möglichkeiten, die Auswerteschaltung, der das Doppler-Signal zugeführt wird, auszugestalten. Gemäß einer bevorzugten Ausgestaltung der Erfindung weist die Auswerteschaltung mindestens einen Verstärker, mindestens einen Bandpaß und mindestens einen Komparator auf.

Der Bandpaß ist dabei auf die zu erwartende Frequenz $f_D$ des Doppler-Signals im Bereich von 10 bis 40 Hz eingestellt, so daß durch den Bandpaß sowohl das Rauschen als auch ein 50 Hz Brummen unterdrückt werden kann. Aufgrund der relativ geringen Frequenz $f_D$ des auszuwertenden Doppler-Signals weist der Verstärker, der vorteilhafterweise als zweistufiger Operationsverstärker ausgebildet ist, nur einen geringen Stromverbrauch auf. Um ein möglichst schnelles Ansprechen des Mikrowellen-Sensors zu gewährleisten, ist der Komparator bevorzugt als Fenster-Komparator ausgebildet, so daß der Komparator zwei Schwellen, sowohl eine positive als auch eine negative Schwelle, aufweist. Dadurch wird durch jede Bewegung eines Objekts innerhalb des überwachten Bereichs sofort ein Signal am Ausgang des Komparators erzeugt, unabhängig von der Richtung der Bewegung. Die Verwendung einer Auswerteschaltung mit einem Fenster-Komparator hat darüber hinaus den Vorteil, daß der Fenster-Komparator so beschaltet werden kann, daß er ohne Ruhestrom arbeitet. Nur bei Betätigung des Mikrowellen-Sensors, d. h. wenn sich ein Objekt im Überwachungsbereich des Mikrowellen-Sensors bewegt, fließt durch den Fenster-Komparator ein Laststrom.

Mit Hilfe eines Spannungsreglers, der zwischen die Strom- bzw. Spannungsversorgung und die Impedanz geschaltet ist und an dessen Ausgang ein Lastwiderstand angeschlossen ist, kann auf die Verwendung einer ansonsten aufwendigeren Endstufe verzichtet werden. Wird der Mikrowellen-Sensor betätigt, so daß der Fenster-Komparator leitend wird und damit ein Laststrom über den Lastwiderstand fließt, so wird ein damit verbundener Spannungseinbruch von dem Spannungsregler durch einen entsprechenden Anstieg des Stromes sofort kompensiert. Da der Lastwiderstand an den Ausgang des Spannungsreglers angeschlossen ist, ist der bei der Betätigung des Mikrowellen-Sensors fließende Strom genau definiert.

Im einzelnen gibt es nun eine Vielzahl von Möglichkeiten, den erfindungsgemäßen Mikrowellen- bzw. Radiowellen-Sensor auszugestalten und weiterzubilden. Dazu wird verwiesen sowohl auf die dem Patentanspruch 1 nachgeordneten Patentansprüche als auch auf die Beschreibung bevorzugter Ausführungsbeispiele in Verbindung mit der Zeichnung. In der Zeichnung zeigen

Fig. 1    ein Prinzipschaltbild eines Ausführungsbeispiels des erfindungs-gemäßen Mikrowellen-Sensors,

Fig. 2    ein Prinzipschaltbild eines Teils eines alternativen Ausführungs-beispiels des erfindungsgemäßen Mikrowellen-Sensors,

Fig. 3    ein Blockschaltbild eines Teils des Mikrowellen-Sensors gemäß Fig.2,

Fig. 4    ein Blockschaltbild eines Mikrowellenmoduls des Mikrowellen-Sensors und

Fig. 5    einen Aufbau eines Mikrowellenmoduls gemäß Fig. 4.

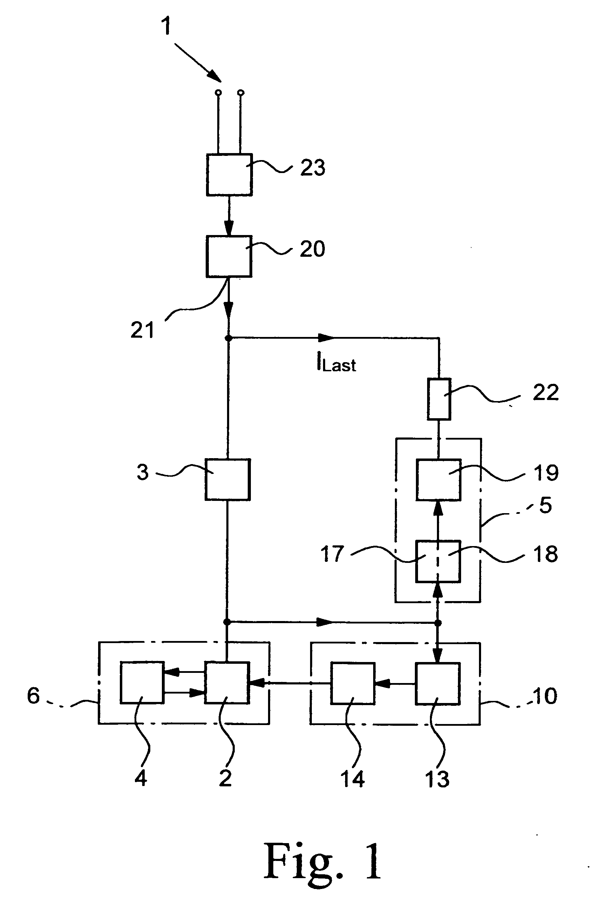

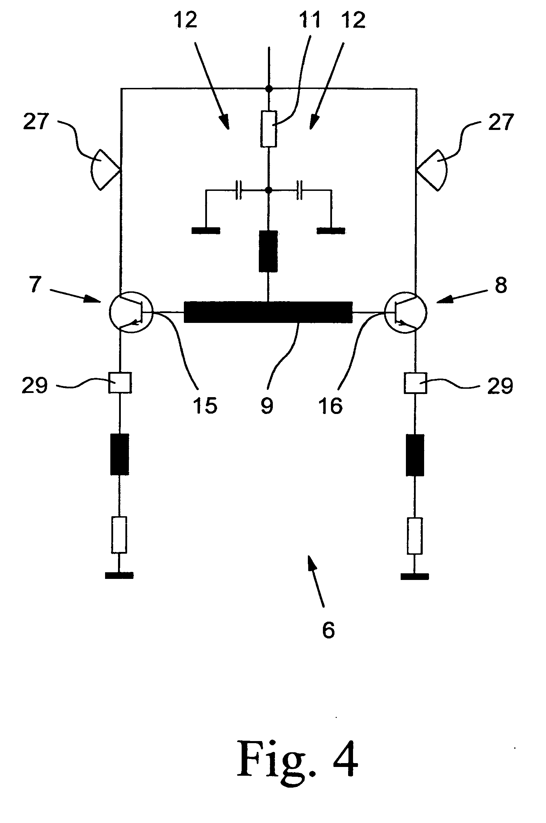

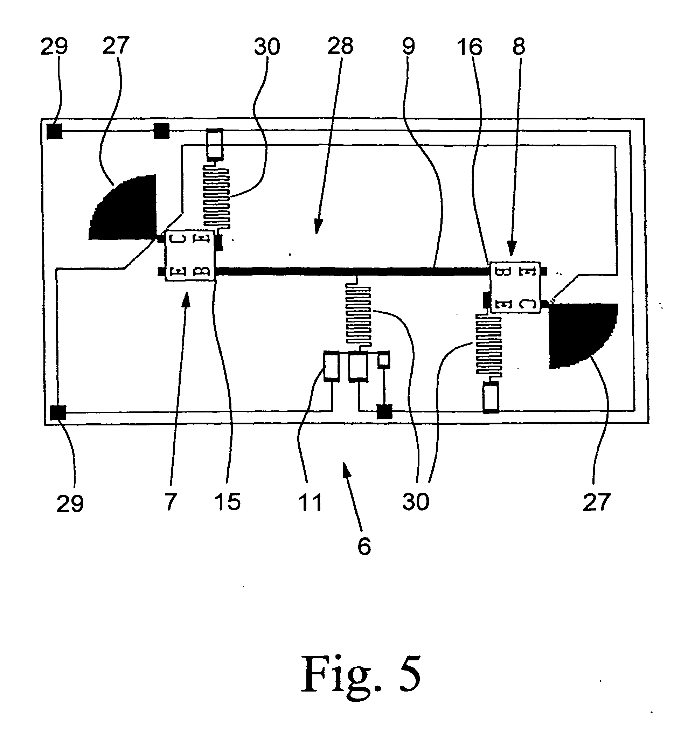

Gemäß dem in Fig. 1 dargestellte Prinzipschaltbild weist der erfindungsgemäße Mikrowellen-Sensor eine Strom- bzw. Spannungsversorgung 1, einen selbstmischenden Oszillator 2, eine Impedanz 3, die zwischen die Strom- bzw. Spannungsversorgung 1 und den selbstmischenden Oszillator 2 geschaltet ist, eine Sende- und Empfangsantenne 4 und eine Auswerteschaltung 5 auf. Der selbstmischende Oszillator 2, der sowohl das Sendesignal erzeugt als auch das Sendesignal mit dem Empfangssignal mischt, bildet zusammen mit der Sende- und Empfangsantenne 4 das hochfrequente Mikrowellenmodul 6, von dem in Fig. 4 ein Blockschaltbild und in Fig. 5 eine Layout-Schaltung dargestellt ist.

Die Fig. 4 und 5 zeigen, daß der selbstmischende Oszillator 2 als symmetrischer Gegentaktoszillator mit zwei Bipolar-Transistoren 7, 8 ausgebildet ist und die Sende- und Empfangsantenne 4 durch eine Streifenleitung 9 gebildet wird. Die Streifenleitung 9, die als λ/2 -Mikrostreifenleitung ausgebildet ist, ist mit ihren beiden Enden jeweils mit dem Basisanschluß 15 bzw. 16 der beiden Bipolar-Transistoren 7, 8 verbunden.

Bei dem in den Fig. 4 und 5 dargestellten Mikrowellenmodul 6, das so aufgebaut und ausgebildet ist, daß der Mikrowellen-Sensor nur einen minimalen Stromverbrauch aufweist, ist zur Einstellung bzw. Stabilisierung des Arbeitspunktes der Transistoren 7, 8 eine Spannungsgegenkopplung 10 mit nur einem Widerstand 11 und zwei Tiefpässen 12 realisiert. Dabei wird für die beiden Tiefpässe 12 der beiden Transistoren 7 und 8 der gleiche Widerstand 11 benutzt, der auch zur Spannungsgegenkopplung verwendet wird.

Nur angedeutet ist in Fig. 1 eine alternative Ausgestaltung der Spannungsgegenkopplung 10, die aus einem Spannungskomparator 13 und einem Integrator 14 besteht. Der Integrator 14 dient dabei, ebenso wie die in den Fig. 4 und 5 dargestellten RC-Glieder, als Tiefpaß, mit einer Grenzfrequenz unterhalb der Doppler-Frequenz $f_D$. Die in der Fig. 1 ebenfalls nur schematisch dargestellte Impedanz 3 kann durch einen Gyrator 3" realisiert sein.

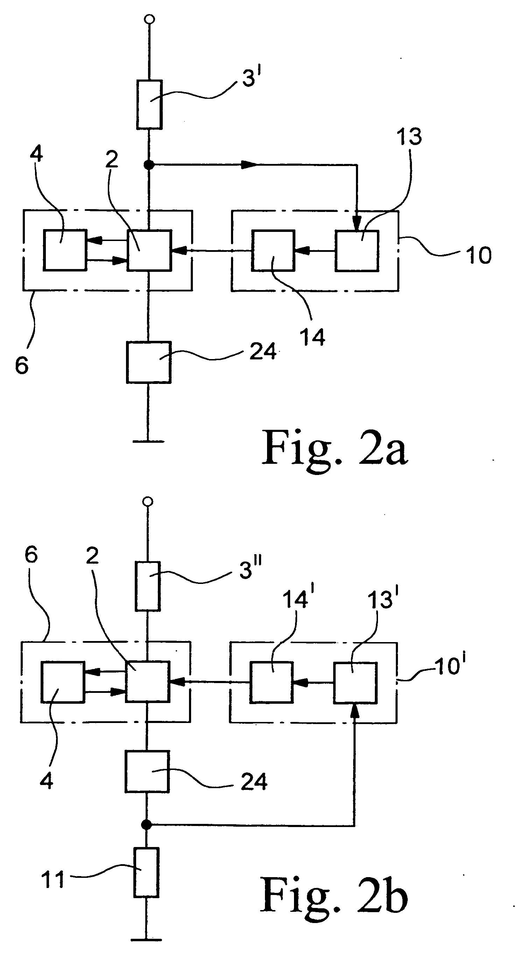

Wie in Fig. 2 zu erkennen ist, erfolgt dann, wenn als Impedanz ein Gyrator 3" verwendet wird der Abgriff der Stromregelung 10' unterhalb der Oszillators 2 erfolgt. Die Stromregelung 10' besteht dabei aus einem Verstärker 13' und einem Tiefpass 14'.

Die nur in Fig. 1 schematisch dargestellte Auswerteschaltung 5 besteht aus einem Verstärker 17, einem Bandpaß 18 und einem Fenster-Komparator 19. Der Verstärker 17 kann dabei als zweistufiger Operationsverstärker ausgebildet sein, wobei der Bandpaß 18 dann durch eine RC-Gegenkopplung der Operationsverstärker realisiert ist. Die Schaltung des Mikrowellen-Sensors weist darüber hinaus noch einen Spannungsregler 20 auf, an dessen Ausgang 21 ein Lastwiderstand 22 angeschlossen ist. Wird der Mikrowellen-Sensor betätigt, d. h. bewegt sich ein Objekt in den überwachten Bereich, so wird der Fenster-Komparator 19 leitend, so daß ein Laststrom über den Lastwiderstand 22 fließt. Der damit verbundene Spannungseinbruch wird durch den Spannungsregler 20 sofort durch einen entsprechenden Anstieg des Stromes kompensiert. Der Spannungsregler 20 sorgt somit für eine konstante Betriebsspannung des Mikrowellen-Sensors, wobei bei einem in Fig. 1 dargestellten 2-Leiter Mikrowellen-Sensor das Ausgangssignal an der Strom- bzw. Spannungsversorgung 1 in Form zweier unterschiedlicher Ströme, Ruhrstrom oder erhöhter Strom bei betätigtem Mikrowellen-Sensor, anliegt. Schließlich ist in Fig. 1 noch eine Schutzschaltung 23 dargestellt, die aus einem Transistor als Vorregler und aus Dioden als Überspannungs- und Verpolschutz besteht.

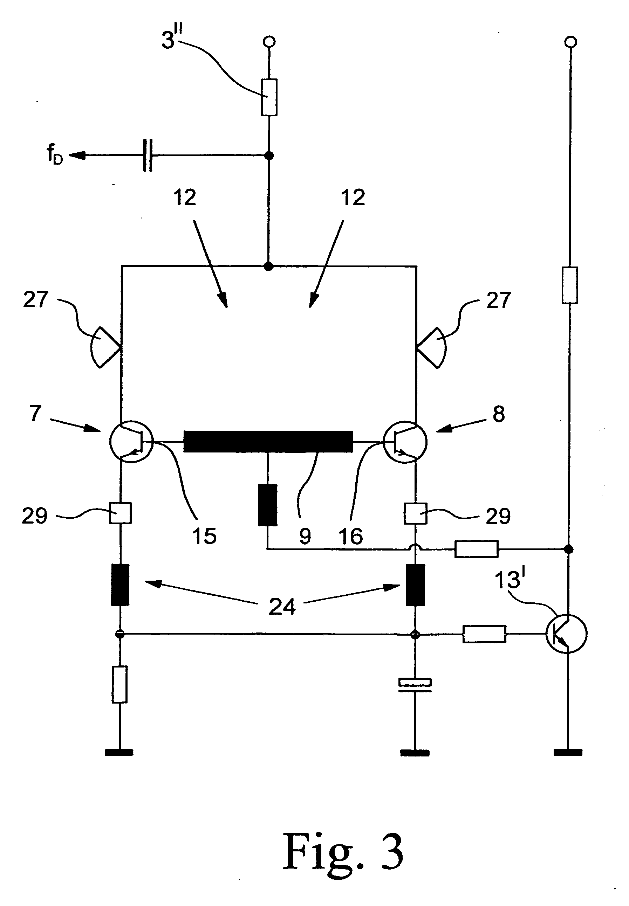

Wie in den Fig. 2, 3 und 4 dargestellt, ist der Oszillator 2 über ein Filter- und Anpaßnetzwerk 24 mit Masse verbunden, um eine möglichst hohe Verstärkung des Nutzsignal zu erreichen. Das Filter- und Anpaßnetzwerk 24 enthält dabei insbesondere jeweils eine Induktivität und einen dazu in Reihe geschalteten niederohmigen Widerstand pro Emitterzweig.

Um das Mikrowellenmodul 6 möglichst einfach und mit möglichst wenig Bauteilen realisieren zu können, sind die Kollektoren 25, 26 der Transistoren 7, 8 durch fächerförmige Dreiecke 27 als Abblockkondensatoren gegen eine Hinterkupferung des Mikrowellenmoduls 6 abgeblockt. Durch die Hinterkupferung des Mikrowellenmoduls 6 wird eine verbesserte Abstrahlcharakteristik der Streifenleitung 9 erreicht, wozu auch die freie Fläche auf der Oberseite 28 des Mikrowellenmoduls 6 - insbesondere benachbart zur Streifenleitung 9 -mit Kupfer ausgefüllt sein kann. Über Kontaktierungspunkte 29 ist die Oberfläche 28 des Mikrowellenmoduls 6 mit der Hinterkupferung auf der Unterseite verbunden. Wie darüber hinaus noch aus Fig. 5 erkennbar ist, sind die Hochfrequenz-Drosseln durch mäanderförmige Leitungen 30 realisiert. Durch diese Maßnahmen können somit zusätzliche Bauteile wie Kondensatoren oder Hochfrequenz-Drosseln entfallen oder besonders einfach realisiert werden.

## Patentansprüche

1. Mikrowellen-Sensor mit einer Strom- bzw. Spannungsversorgung (1), mit einem selbstmischenden Oszillator (2), mit einer Sende- und Empfangsantenne (4) und mit einer Auswerteschaltung (5), wobei der selbstmischende Oszillator (2) sowohl das Sendesignal erzeugt als auch das Sendesignal mit dem Empfangssignal mischt, wobei das niederfrequente Mischprodukt ein Doppler-signal bzw, zwischensignal darstellt, und wobei der selbstmischende Oszillator (2) als Gegentaktoszillator mit zwei Transistoren (7, 8) ausgebildet ist,
   **dadurch gekennzeichnet,**
   **daß** eine Impedanz (3) zwischen die Strom- bzw. Spannungsversorgung (1) und den Oszillator (2) geschaltet ist und das niederfrequente Mischprodukt an der Impedanz (3) abgegriffen und der Auswerteschaltung (5) zugeführt wird, und
   **daß** die Impedanz (3) einen frequenzabhängigen Widerstandswert aufweist, wobei die Impedanz (3) so ausgelegt ist, daß sie für die Gleichstrom- bzw. Gleichspannungsversorgung des selbstmischenden Oszillator (2) niederohmig und für das Doppler-Signal bzw. das Zwischensignal hochohmig ist

2. Mikrowellen-Sensor nach Anspruch 1, **dadurch gekennzeichnet, daß** die Sende- und Empfangsantenne (4) durch eine die Frequenz des Gegentaktoszillators bestimmende Streifenleitung (9) gebildet ist.

3. Mikrowellen-Sensor nach Anspruch 1 oder 2, **dadurch gekennzeichnet, daß** zur Einstellung bzw. Stabilisierung des Arbeitspunktes eine Spannungsgegenkopplung (10) oder eine Stromregelung (10') mit mindestens einem Widerstand (11) und mit einem Tiefpaß (12, 14') realisiert ist, wobei die Arbeitspunktregelung langsamer als die niedrigste zu erwartende Doppler-Frequenz $f_D$ bzw. die niedrigste Zwischenfrequenz $F_{ZF}$ ist.

4. Mikrowellen-Sensor nach einem der Ansprüche 1 bis 3, **dadurch gekennzeichnet, daß** die Impedanz (3) als elektronische Drossel, insbesondere als Gyrator (3") ausgebildet ist.

5. Mikrowellen-Sensor nach einem der Ansprüche 2 bis 4 mit einer Streifenleitung (9), **dadurch gekennzeichnet, daß** als Transistoren (7, 8) Bipolar-Transistoren verwendet sind, und die Streifenleitung (9) mit dem Basisanschluß (15, 16) der beiden Bipolar-Transistoren (7, 8) verbunden ist.

6. Mikrowellen-Sensor nach einem der Ansprüche 2 bis 5 mit einer Streifenleitung (9), **dadurch gekennzeichnet, daß** die Streifenleitung (9) mit einem dielektrischen Resonator verbunden ist.

7. Mikrowellen-Sensor nach einem der Ansprüche 2 bis 5 mit einer Streifenleitung (9), **dadurch gekennzeichnet, daß** die Streifenleitung (9) als $\lambda/2$ - Mikrostreifenleitung ausgebildet ist und eine Hinterkupferung aufweist.

8. Mikrowellen-Sensor nach einem der Ansprüche 1 bis 7, **dadurch gekennzeichnet, daß** die Auswerteschaltung (5) mindestens einen Verstärker (17), mindestens einen Bandpaß (18) und mindestens einen Komparator, insbesondere einen Fenster-Komparator (19), aufweist.

9. Mikrowellen-Sensor nach Anspruch 8, **dadurch gekennzeichnet, daß** der Verstärker (17) als zweistufiger Operationsverstärker mit jeweils einer RC-Gegenkopplung ausgebildet ist.

10. Mikrowellen-Sensor nach Anspruch 8 oder 9 mit einem Fenster-Komparator (19), **dadurch gekennzeichnet, daß** der Fenster-Komparator (19) im Ruhezustand stromlos ist.

11. Mikrowellen-Sensor nach einem der Ansprüche 1 bis 10, **dadurch gekennzeichnet, daß** ein Spannungsregler (20) vorgesehen ist, der Spannungsregler (20) zwischen die Strom- bzw. Spannungsversorgung (4) und die Impedanz (3) geschaltet ist und an den Ausgang (21) des Spannungsreglers (20) ein Lastwiderstand (22) angeschlossen sind.

## Claims

1. Microwave sensor with a current or voltage supply (1), with a self-mixing oscillator (2), with a transmitting and receiving antenna (4) and with an evaluating circuit (5), wherein the self-mixing oscillator (2) producing both the transmitted signal and also mixing the transmitted signal with the received signal, the low-frequency mixed product representing a Doppler signal or intermediate signal, and wherein the self-mixing oscillator (2) is made as push-pull oscillator with two transistors (7, 8), **characterized in that**, an impedance (3) is connected between the current or voltage supply (1) and the oscillator (2) and the low-frequency mixed product being tapped on the impedance (3) and supplied to the evaluating circuit (5), and **that** the impedance (3) has a frequency-dependent impedance value, the impedance (3) being designed in such a manner that it has a low resistance for the direct-current or direct-voltage supply of the self-mixing oscillator (2) and a high resistance for the Doppler signal or the intermediate signal, respectively.

2. Microwave sensor according to Claim 1, **characterized in that** the transmitting and receiving antenna (4) is formed by a strip line (9) determining the frequency of the push-pull oscillator.

3. Microwave sensor according to Claim 1 or 2, **characterized in that**, in order to adjust or stabilize the operating point, a voltage inverse feedback (10) or a current control (10') is implemented, having at least one resistor (11) and one low-pass filter (12, 14'), wherein the operating point control being slower than the lowest expected Doppler frequency $f_D$ or the lowest intermediate frequency $F_{ZF}$.

4. Microwave sensor according to one of Claims 1 to 3, **characterized in that** the impedance (3) is made as an electronic choke, particularly as a gyrator (3").

5. Microwave sensor according to one of Claims 2 to 4, comprising a strip line (9), **characterized in that** bipolar transistors are used as transistors (7, 8) and the strip line (9) is connected to the base terminal (15, 16) of the two bipolar transistors (7, 8).

6. Microwave sensor according to one of Claim 2 to 5, comprising a strip line (9), **characterized in that** the strip line (9) is connected to a dielectric resonator.

7. Microwave sensor according to one of Claims 2 to 5, comprising a strip line (9), **characterized in that** the strip line (9) is constructed as a λ/2 microstrip line and has a rear copper coating.

8. Microwave sensor according to one of Claims 1 to 7, **characterized in that** the evaluating circuit (5) has at least one amplifier (17), at least one band-pass filter (18) and at least one comparator, particularly a window comparator (19).

9. Microwave sensor according to Claim 8, **characterized in that** the amplifier (17) is constructed as a two-stage operational amplifier each having a RC feedback.

10. Microwave sensor according to Claim 8 or 9, comprising a window comparator (19), **characterized in that** the window comparator (19) is currentless in the idle state.

11. Microwave sensor according to one of Claims I to 10, **characterized in that** a voltage controller (20) is provided, the voltage controller (20) is connected between the current or voltage supply (1) and the impedance (3) and a load resistor (22) is connected to the output (21) of the voltage controller (20).

## Revendications

1. Détecteur à micro-ondes avec une source de courant respectivement de tension (1), avec un oscillateur automélangeur (2), avec une antenne de transmission et de réception (4) et avec un circuit d'évaluation (5), dans lequel l'oscillateur automélangeur (2) d'une part produit le signal de transmission et d'autre part mélange le signal de transmission avec le signal de réception, dans lequel le produit mélangé à basse fréquence représente un signal Doppler, respectivement un signal intermédiaire, et dans lequel l'oscillateur automélangeur (2) est formé par un oscillateur symétrique avec deux transistors (7, 8), **caractérisé en ce qu'**une impédance (3) est montée entre la source de courant respectivement de tension (1) et l'oscillateur (2) et le produit mélangé à basse fréquence est prélevé sur l'impédance (3) et envoyé au circuit d'évaluation (5), et **en ce que** l'impédance (3) présente une valeur de résistance dépendant de la fréquence, dans lequel l'impédance (3) est conçue de telle manière qu'elle soit faiblement ohmique pour la source de courant continu respectivement de tension continue de l'oscillateur automélangeur (2) et hautement ohmique pour le signal Doppler respectivement le signal intermédiaire.

**2.** Détecteur à micro-ondes selon la revendication 1, **caractérisé en ce que** l'antenne de transmission et de réception (4) est formée par un guide d'ondes à ruban (9) déterminant la fréquence de l'oscillateur symétrique.

**3.** Détecteur à micro-ondes selon la revendication 1 ou 2, **caractérisé en ce que**, pour le réglage respectivement la stabilisation du point de travail, on a réalisé une contre-réaction de tension (10) ou une régulation de courant (10') avec au moins une résistance (11) et avec un passe-bas (12, 14'), dans lequel la régulation du point de travail est plus lente que la plus basse fréquence Doppler $F_D$ à envisager respectivement que la plus basse fréquence intermédiaire $F_{ZF}$.

**4.** Détecteur à micro-ondes selon l'une quelconque des revendications 1 à 3, **caractérisé en ce que** l'impédance (3) est réalisée par une bobine de réactance électronique, en particulier un gyrator (3 ").

**5.** Détecteur à micro-ondes selon l'une quelconque des revendications 2 à 4 avec un guide d'ondes à ruban (9), **caractérisé en ce que** l'on utilise comme transistors (7, 8) des transistors bipolaires, et le guide d'ondes à ruban (9) est raccordé à la borne de base (15, 16) des deux transistors bipolaires (7, 8).

**6.** Détecteur à micro-ondes selon l'une quelconque des revendications 2 à 5 avec un guide d'ondes à ruban (9), **caractérisé en ce que** le guide d'ondes à ruban (9) est raccordé à un résonateur diélectrique.

**7.** Détecteur à micro-ondes selon l'une quelconque des revendications 2 à 5 avec un guide d'ondes à ruban (9), **caractérisé en ce que** le guide d'ondes à ruban (9) est formé par un guide d'ondes à ruban 1/2 et présente un cuivrage arrière.

**8.** Détecteur à micro-ondes selon l'une quelconque des revendications 1 à 7, **caractérisé en ce que** le circuit d'évaluation (5) comprend au moins un amplificateur (17), au moins un passe-bande (18) et au moins un comparateur, en particulier un comparateur à fenêtre (19).

**9.** Détecteur à micro-ondes selon la revendication 8, **caractérisé en ce que** l'amplificateur (17) est formé par un amplificateur opérationnel à deux étages avec chaque fois une contre-réaction RC.

**10.** Détecteur à micro-ondes selon la revendication 8 ou 9 avec un comparateur à fenêtre (19), **caractérisé en ce que** le comparateur à fenêtre (19) est sans courant à l'état de repos.

**11.** Détecteur à micro-ondes selon l'une quelconque des revendications 1 à 10, **caractérisé en ce qu'**il est prévu un régulateur de tension (20), le régulateur de tension (20) est monté entre la source de courant respectivement de tension (1) et l'impédance (3) et une résistance de charge (22) est raccordée à la sortie (21) du régulateur de tension (20).

Fig. 1

Fig. 2a

Fig. 2b

Fig. 3

Fig. 4

Fig. 5